# EUROPEAN PATENT APPLICATION

(11) **EP 4 683 488 A1**
(43) Date of publication of application: **21.01.2026**
(21) Application number: 24275083.4
(22) Date of filing: 15.07.2024
(51) Int. Cl.: H10N 70/20, H10B 63/00, H01P 1/10, H01Q 3/44, H01Q 15/00

(54) **SWITCHING DEVICE, ANTENNA AND FREQUENCY SELECTIVE SURFACE COMPRISING THE SWITCHING DEVICE, AND METHOD OF USING THE SWITCHING DEVICE**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

Provided is a switching device (100) comprising a dielectric substrate (130) between a first electrode arrangement (110) and a second electrode arrangement (120), the dielectric substrate comprising a plurality of switching regions (140), the switching regions comprising mobile ions which are repositionable by application of a programming voltage. By control of the programming voltage, the switching device is selectively configurable in a first state wherein, in a first subset, each switching region is in a first condition wherein the mobile ions are positioned so that a conductive path is provided across the switching region and, in a second subset, each switching region is in a second condition wherein the mobile ions are positioned so that a conductive path is not provided across the switching region.

## Description

### FIELD

The present invention relates to a switching device, an antenna comprising a switching device, a frequency selective surface comprising a switching device, and a related method.

### BACKGROUND

A wireless communication system operating in a radio frequency range requires an antenna to convert an electromagnetic wave into an electrical current indicative of the received signal and vice versa. Selective control of electromagnetic (EM) waves received and/or transmitted by antenna is limited.

Switching devices are employed in wireless communication systems to enable antenna reconfigurability. Commercially available switching devices include transistors and micro-electromechanical systems (MEMS) switches. Transistor-based switches are advantages in provided high switching speed. However, these switches are embedded in the semiconductor substrate, which adds a parasitic component and is influenced by radio frequency (RF) field energy, thereby reducing RF immunity. MEMS switches provide improved isolation between switched terminals. The structure of a MEMS switch is isolated from the semiconductor substrate, thereby reducing parasitic components and RF interference. However, MEMS devices rely on mechanical movement of 3D structures. Consequently, lower switching speed is exhibited.

Additionally, antenna miniaturisation poses higher performance demands for switching devices. High energy RF field, combined with thermal fluctuations, increases the risk of device malfunction.

It is an aim of embodiments of the present invention to at least partially avoid or overcome one or more disadvantages of the prior art, whether identified herein or elsewhere, or to at least provide an alternative to existing switching devices, antennae, frequency selective surfaces, and methods.

### SUMMARY

According to a first aspect of the present invention, there is provided a switching device comprising: a first electrode arrangement and a second electrode arrangement; and a dielectric substrate between the first electrode arrangement and the second electrode arrangement, wherein the dielectric substrate comprises a plurality of switching regions, wherein the switching regions comprise mobile ions which are repositionable by application of a programming voltage, wherein, by control of the programming voltage, the switching device is selectively configurable in a first state wherein: in a first subset of the plurality of switching regions, each switching region is in a first condition wherein the mobile ions are positioned so that a conductive path is provided across the switching region; and in a second subset of the plurality of switching regions, each switching region is in a second condition wherein the mobile ions are positioned so that a conductive path is not provided across the switching region.

In one example, in the first state, by control of the programming voltage, the ratio of the switching regions in the first condition to switching regions in the second condition is controllable by control of the programming voltage.

In one example, by control of the programming voltage, the switching device is further selectively configurable in a second state wherein: each switching region of the plurality of switching regions is in the first condition.

In one example, by control of the programming voltage, the switching device is further selectively configurable in a third state wherein: each switching region of the plurality of switching regions is in the second condition.

In one example, the plurality of switching regions are integrally formed in the dielectric substrate.

In one example, the plurality of switching regions are provided as a 2D array.

In one example, the switching regions are arranged in one or more linear arrays provided at a constant separation from the first electrode arrangement and/or the second electrode arrangement.

In one example, the switching device comprises a wafer substrate.

In one example, the dielectric substrate is provided on one surface of the wafer substrate, wherein a gap is provided between the dielectric substrate and the wafer substrate in at least an area of the dielectric substrate in which the plurality of switching regions are provided.

In one example, a plurality of apertures are formed in the dielectric substrate in the area of the dielectric substrate in which the plurality of switching regions are provided.

In one example, the switching device further comprises a controller configured to control the application of the programming voltage.

In one example, above a first threshold of programming voltage, all switching regions are configured in the first condition, and wherein below a second threshold of programming voltage, all switching regions are configured in the second condition, and wherein the controller is configured to control the application of the programming voltage to: apply a programming voltage between first threshold and second threshold, thereby to configure first subset in first condition, and configure second subset in second condition.

According to a second aspect of the present invention, there is provided an antenna comprising the switching device according to the first aspect.

According to a third aspect of the present invention, there is provided a frequency selective surface comprising the switching device according to the first aspect.

According to a fourth aspect of the present invention, there is provided a method of use of a switching device, the switching device comprising: a first electrode arrangement and a second electrode arrangement; and a dielectric substrate between the first electrode arrangement and the second electrode arrangement, wherein the dielectric substrate comprises a plurality of switching regions, wherein the switching regions comprise mobile ions which are repositionable by application of a programming voltage, the method comprising: controlling the programming voltage to configure the switching device in a first state wherein: in a first subset of the plurality of switching regions, each switching region is in a first condition wherein the mobile ions are positioned so that a conductive path is provided across the switching region; and in a second subset of the plurality of switching regions, each switching region is in a second condition wherein the mobile ions are positioned so that a conductive path is not provided across the switching region.

In one example, the method further comprises controlling the programming voltage to control the ratio of switching regions in the first condition to switching regions in the second condition.

Features of any one of the aspects of the present invention may be combined with features of any other aspect of the present invention, as desired or as appropriate.

### BRIEF DESCRIPTION OF THE FIGURES

Embodiments of the invention will now be described by way of example only with reference to the figures, in which:
Figure 1 shows a side cross-sectional view of a switching device;
Figure 2 shows a plan view of the switching device of Figure 1;
Figure 3 shows a schematic antenna;
Figure 4 shows a schematic frequency selective surface; and
Figure 5 shows general methodology principles.

### DETAILED DESCRIPTION

In overview, a switching device is provided, in which an operating characteristic (e.g., impedance, ohmic, and/or capacitive characteristic) of the device is controllable by application of a programming voltage, or programming bias. The switching device demonstrates high switching speed, and reduced sensitivity to external RF fields. Notably, the switching device may exhibit non-volatile memory. That is, by application of the programming voltage, a state of the switching device may be configured, and retained, when the programming voltage is removed. In this way, the switching device may operate as a "memimpedance", "memresistance", or "memcapacitance" device, having memimpedance, memristive, or memcapacitive characteristics. The programming voltage may include programming the switching device 100 using voltage amplitude, pulse width, or a number of pulses.

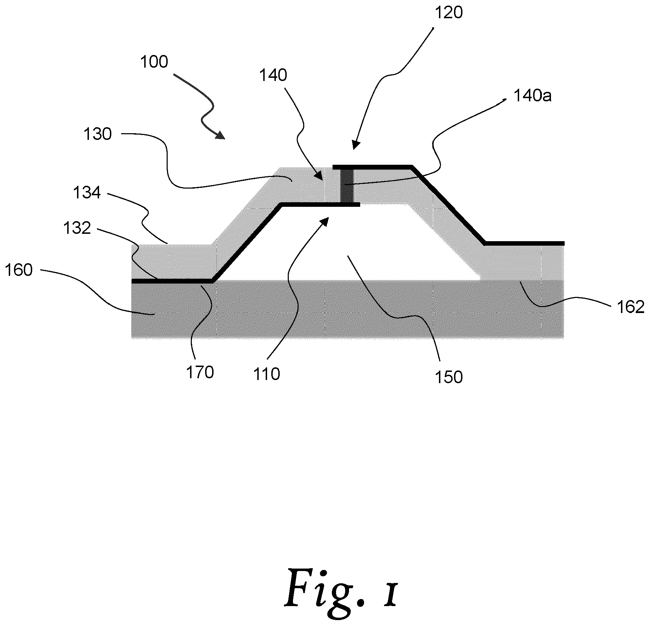

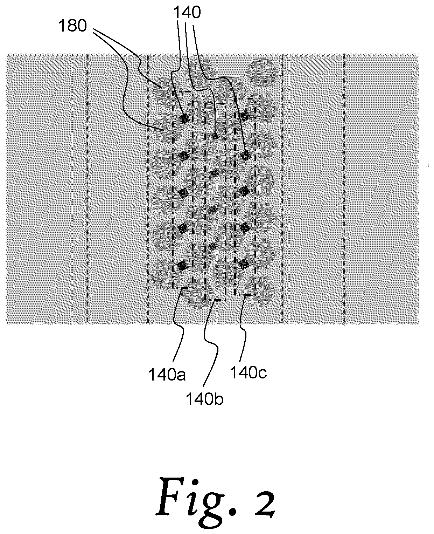

Referring to Figures 1 and 2, a switching device 100 is shown. The switching device 100 comprises a first electrode arrangement 110 and a second electrode arrangement 120. The switching device 100 further comprises a dielectric substrate 130. The dielectric substrate 130 is between the first electrode arrangement 110 and the second electrode arrangement 120. The dielectric substrate 130 comprises a plurality of switching regions 140.

The switching regions 140 comprise mobile ions. The mobile ions are repositionable by application of a programming voltage, as will be described in greater detail below. By control of the programming voltage, the switching device 100 is selectively configurable in one or more states, or configurations.

In particular, by control of the programming voltage, the switching device 100 is selectively configurable in a first state. In the first state, in a first subset of the plurality of switching regions 140, each switching region 140 (i.e., of the first subset) is in a first condition. In the first condition, the mobile ions are positioned so that a conductive path is provided across the switching region 140. In the first state, in a second subset of the plurality of switching regions 140, each switching region 140 (i.e., of the second subset) is in a second condition. In the second condition, the mobile ions are positioned so that a conductive path is not provided across the switching region 140.

Numerous advantages are realised by the present construction. For example, in this way, in this way, a non-volatile memimpedance switching device 100 is provided, where the device is programmable by application of the programming voltage, and the state of the device maintained subsequent to removal of the programming voltage. This is particularly advantageous when applied to antenna cell tuning, and/or as part of a frequency selective surface. A further advantage is realised where the memimpedance switching device is programmed to detect a high-power RF signal intended to damage an associated antenna. The memimpedance switch programmed, or tuned, to detect such a signal can be used to detune the antenna, thereby preventing damage.

The switching device 100 will now be described in greater detail.

The mechanism of programming, or tuning, the switching device 100 relies on the repositioning of the mobile ions in the dielectric substrate 130. The dielectric substrate 130 may be a thin film substrate. The dielectric substrate 130 preferably has a low dielectric constant. This is advantageous in reducing capacitive and RF coupling to the switching regions 140. In this way, reduced parasitic effects and higher immunity to electromagnetic interference can be achieved. This is particularly advantageous for high switching speed. The dielectric substrate 130 may be doped with mobile ions - that is, ions which may be moved within the dielectric substrate 130 under the influence of an electric field. An example of a suitable dielectric is titanium oxide, with oxygen ions providing the mobile ions. The mobile ions are repositionable in, or into, the switching regions 140 due to an electric field established between the first electrode arrangement 110 and the second electrode arrangement 120. This may be understood as ion "drift". By application of the programming voltage, the mobile ions can be caused to move (i.e., repositioned), to provide, or not provide, a conductive path across the switching regions 140, between electrodes of the electrode arrangements 110, 120, thereby creating desired properties of the switching regions 140. The switching regions 140 may otherwise be referred to as "switching zones". Switching regions 140 may be present in regions of spatial overlap between the first electrode arrangement 110 and the second electrode arrangement 120. In Figure 1, an exemplary first switching region 140a of the plurality of switching regions 140 is shown, where electrode overlap is exhibited. Switching regions may be known as such because of the ability to be switched (e.g., by movement of mobile ions) to selectively form conductive, or nonconductive, regions. Electrical current flow within the device 100 can thereby be controlled.

Collectively, the plurality of switching regions 140 are configurable such that one or more switching regions 140 provide a conductive region, and one or more remaining switching regions 140 provide a capacitive region.

A conductive (e.g., ohmic) switching region of the plurality of switching regions 140 may comprise mobile ions positioned therein to span or extend between an electrode of the first electrode 110 and a corresponding electrode of the second electrode 120, enabling current flow between the electrodes 110, 120. An appropriate level of programming voltage is utilised to position the mobile ions in this way.

A capacitive switching region of the plurality of switching regions 140 may comprise mobile ions, but a dielectric region, or gap, may be present between am electrode of the first electrode arrangement 110 and a corresponding electrode of the second electrode arrangement 120. That is, the mobile ions are positioned therein so as not to span or extend between said electrodes, such that a dielectric region separates the electrodes. Accordingly, a conductive path is not provided. Current flow is thereby prevented between said electrodes.

It will be appreciated that by configuring the switching device 100 to simultaneously have one or more conductive switching regions and one or more capacitive switching regions, the switching device 100 exhibits an impedance characteristic. Advantageously, the relative proportion of the different regions may be adjusted to tune the impedance characteristic of the switching device 100. Furthermore, by configuring the switching device 100 to have only conductive switching regions, the switching device 100 exhibits a resistive characteristic, and, alternatively, by configuring the switching device 100 to have only capacitive switching regions, the switching device 100 exhibits a capacitive characteristic.

Furthermore, as introduced above, the switching device 100 exhibits non-volatile memory of the configuration of the characteristic. That is, when the programming voltage is removed, the mobile ions maintain their position in the switching regions 140 as caused by the application of the programming voltage. In this way, the switching device 100 maintains a level of impedance, resistance or capacitance, and may thus be referred to as a memimpedance, memresistance, or memcapacitance device 100, with the device 100 being selectively configurable to have each of those characteristics.

Referring to Figure 1, the switching device 100 shown in a side cross-sectional view. A single switching region 140a is visible.

The dielectric substrate 130 is between the first electrode arrangement 110 and the second electrode arrangement 120. The dielectric substrate 130 may be interposed between the first electrode arrangement 110 and the second electrode arrangement 120.

The first electrode arrangement 110 may comprise one or more first electrodes. The second electrode arrangement 120 may comprise one or more second electrodes. In an example, the first electrode arrangement 110 is provided at a first surface 132 of the dielectric substrate 130, and the second electrode arrangement 120 is provided at a second surface 134 of the dielectric substrate 130, the second surface 134 being opposite the first surface 132. That is, corresponding pairs of electrodes may be provided either side of the dielectric substrate 130, which may be referred to as a vertically separated arrangement. Advantageously, by the present construction, the necessary spacing between electrodes results in a construction which facilitates device size which may be smaller than that of a MEMS device. Alternatively, in a further example, corresponding pairs of electrodes may be provided in a co-planar arrangement, and a switching region formed in the plane between the electrodes. This may be referred to as a horizontally separated arrangement.

The first electrode arrangement 110 may comprise a plurality of conductive tracks. End regions of the conductive tracks provide, or define, a plurality of first electrodes. The second electrode arrangement 120 may comprise a plurality of conductive tracks. End regions of the conductive tracks provide, or define, a plurality of second electrodes. The first electrodes and second electrodes may be provided in corresponding pairs on either side of a switching region of the plurality of switching regions 140. In this way, each switching region may be individually addressable. By individually addressing each switching region, each switching region may be programmed differently to one or more other switching regions, such that, for example, a first switching region provides a conductive region and a second switching region provides a capacitive region.

Alternatively, the first electrode arrangement 110 and second electrode arrangement 120 may each comprise a single conductive track. An end region of each conductive track provides, or defines, an electrode (i.e., a first and second electrode). Switching regions may not be individually addressable, but the switching regions may be configured to change characteristic (e.g., capacitive to resistive) at different programming voltages, for example by a variation in dimension of respective switching regions.

Alternatively, one of the first or second electrode arrangements 110, 120 may comprise a single conductive track or element, and the other electrode arrangement 110, 120 may comprise a plurality of conductive tracks. Advantageously, in this way, switching regions may be individually addressable, but manufacture is simplified as the more complex plurality of conductive tracks need only be fabricated for one of the electrode arrangements 110, 120.

The dielectric substrate 130 may be provided on a wafer substrate 160. In an example, the switching device 100 may comprise a wafer substrate 160. In another example, the wafer substrate 160 may be separate to the switching device 100, and the switching device 100 provided on the wafer substrate 160. The wafer substrate may be formed of silicon, silicon germanium, gallium arsenide, or any other suitable material, as will be understood by the skilled person. In an example, the dielectric substrate 130 is provided on a first surface 162 of the wafer substrate 160, which may be an upper surface of the wafer substrate 160. The switching device 100, including the dielectric substrate 130, may be packaged as an integral unit, which may include vacuum packaging the switching device 100. Advantageously, in this way, the switching device 100 can be electrically isolated. Furthermore, in this way, changes or fluctuations in pressure do not influence or impact the vacuum-packed switching device 100. The first electrode arrangement 110 may be electrically connected to the wafer substrate 160.

When the dielectric substrate 130 is provided on a surface of the wafer substrate 160, a gap 150 is provided between the dielectric substrate 130 and the wafer substrate 160. The gap 150 is provided in at least an area of the dielectric substrate 160 in which the plurality of switching regions 140 are provided. Highly advantageously, in this way, the switching regions 140 (or the switching device 100 itself) are decoupled from the wafer substrate 160, which may include electrical, and/or thermal decoupling/isolation from the wafer substrate 160. The dielectric substrate 130 is however mechanically connected to the wafer substrate 160. Providing the gap (i.e., an air gap) will reduce capacitive coupling to the wafer substrate. In some examples, this may be referred to as an "air-bridge". The dielectric substrate 130 may be said to have a suspended form, cantilever structure, or a bridge-like structure. In other examples, the dielectric substrate 130 may have a diaphragm (e.g., thin flexible disc or layer) structure, or a "mushroom" shaped structure, with the dielectric substrate 130 mounted on a central stem to form a suspended structure. Advantageously, a cantilever or mushroom-like structure provides good mechanical isolation from stresses of the substrate 130 (e.g., from bending, twisting, warping, etc.). Furthermore, a diaphragm structure may be suspended on pillars above the dielectric substrate 130, and comprise embedded stress-isolating structures, thereby reducing mechanical coupling from the dielectric substrate 130. The structures described herein are advantageous in high G-force or vibration environments.

Referring to Figure 2, the switching device 100 is shown in plan view. In Figure 2, the second electrode arrangement 120 is not shown, for clarity.

A plurality of apertures 180 may be formed in, or through, the dielectric substrate 130. The plurality of apertures 180 may be provided in the area of the dielectric substrate 130 in which the plurality of switching regions 140 are provided. That is, the plurality of apertures 180 may be provided in the suspended area of the dielectric substrate 130. The apertures 180 may each have a hexagonal form. The apertures 180 may be arranged in a hexagonal, or honeycomb, lattice. The dielectric substrate 130 may therefore be referred to as having a perforated lattice bridge structure. Advantageously, the perforated lattice bridge structure further reduces parasitic component coupling to the wafer substrate 160. Furthermore, the perforation lattice bridge structure may constrain the location of mobile ions into the remaining beam regions between the apertures 180. Additionally, by a hexagonal, or honeycomb, lattice, a high packing ratio of switching regions 140 is achieved, whilst allowing the switching device 100 to handle high power levels.

The switching regions 140 are distributed across the dielectric substrate. The switching regions 140 may be arranged into one or more linear arrays 140a, 140b, 140c of switching regions. The plurality of switching regions may be provided as a 2D array. That the switching regions may be laterally distributed across the dielectric substrate. Providing one or more arrays of switching regions 140 is advantageous in increasing switching reliability, redundancy and ability to handle larger power levels. In other examples, the plurality of switching regions are provided as a 3D array in a vertically stacked device, or multiple stacks of switching devices. As the device 100 disclosed herein dissipates less power during switching cycle than e.g., a transistor, the present device 100 is less constrained by thermal effects, and thus vertical stacking may be facilitated. In this way, chip area and cost per device can be reduced.

As introduced above, the switching regions 140 may be provided between adjacent apertures 180, or perforations, in the suspended area of the dielectric substrate. That is, the switching regions 140 may be provided, or defined, in the beams of dielectric substrate between the apertures 180.

The switching device may further comprise a controller (not shown). The controller may be configured to control the application of the programming voltage. The controller may control the magnitude of the programming voltage. Additionally, or alternatively, the controller may control which of the switching regions 140 are addressed with the programming voltage. Programming pulses may be provided or controlled by the controller to address each of the switching regions 140.

Programming of the switching device 100 will now be described.

The switching device 100 is configurable, or is programmable, in a first state by application of the programming voltage.

In the first state, mobile ions are repositioned, by appropriate application of the programming voltage, so as to provide a conductive path between electrodes to thereby provide the first subset of switching regions. The appropriate programming voltage may be at, or in excess of, a first threshold level, the first threshold level being a level required to position the mobile ions so as to establish a complete conductive path between electrodes. Each switching region of the first subset may be known as being provided, or configured, in a first condition. The first condition may be a resistive, or ohmic, condition by virtue of enabling current flow but providing a resistive path to current flow. The first subset of switching regions may be addressed (or targeted) by the controller providing appropriate programming voltage to the electrodes corresponding to the first subset of switching regions. A forward bias programming voltage may be utilised.

Additionally, in the first state, mobile ions are repositioned, by appropriate application of a programming voltage, so that a conductive path is not provided between electrodes, to thereby provide the second subset of switching regions. The appropriate programming voltage may be less than the first threshold level. A conductive path between the electrodes is not provided when the mobile ions do not form a complete path spanning between the electrodes. For example, for the second subset of switching regions, a dielectric region may exist, or be formed, between the electrodes and thus a conductive path is not established.

Each switching region of the second subset may be known as being provided, or configured, in a second condition. The second condition may be a capacitive condition by virtue of preventing current flow but enabling a build-up of charge at the respective electrodes. The second subset of switching regions may be addressed (or targeted) by the controller providing appropriate programming voltage to the electrodes corresponding to the second subset of switching regions. A reverse bias programming voltage may be utilised, or a forward bias programming voltage may instead being utilised which is lower than that necessary to form a complete conductive path. In an example, a programming voltage may be utilised that is lower than that required to result in drift of the mobile islands across the switching zone to provide a conductive bridge. That is if the programming voltage does not cause diffusion of the ions fully across the switching region to bridge between the electrodes, the remaining dielectric region will prevent current flow.

In an example, the same programming voltage level may cause first subset of the switching regions to be provided, or configured, in the first condition, whilst the second subset of the switching regions are provided, or configured, in the second condition. This may be due to use of different materials, shapes, or dopants in the respective switching regions. Circuit complexity may thereby be reduced, as the complexity of the electrode arrangements (or conductive tracks thereof) may be reduced, by reducing the number of conductive tracks required to address the switching regions 140. Alternatively, this may be due to the positioning of the switching regions. For example, switching regions which are closer to the electrodes will experience a higher electric field and therefore a greater level of diffusion of the mobile ions. In contrast, switching regions which are at greater separation from the electrodes will experience a lower electric field and therefore a reduced level of diffusion of the mobile ions.

As described above, the switching device 100 is selectively configurable in one or more states. In the first state, a first subset of the switching regions 140 are resistive, whilst a second subset of the switching regions 140 are capacitive. Consequently, the switching device 100 has an impedance characteristic.

By control of the programming voltage, the ratio of the switching regions in the first condition to switching regions in the second condition is controllable by control of the programming voltage. That is, the ratio of the first subset to the second subset is controllable. In this way, the impedance value of the switching device 100 can be controlled.

The switching device 100 is further configurable in a second state. By control of the programming voltage, all switching regions of the plurality of switching regions 140 may be configured in the first condition. That is, a conductive path may be established between all corresponding electrodes of the switching device 100. In this way, the switching device 100 is or has a resistive characteristic, but has no capacitive characteristic.

The switching device 100 is further configurable in a third state. By control of the programming voltage, all switching region of the plurality of switching regions 140 may be configured in the second condition. That is, a conductive path is not established between any corresponding electrodes of the switching device 100. In this way the switching device 100 is or has a capacitive characteristic, but has no resistive characteristic.

In an example, the controller is configured to control the application of the programming voltage. Above a first threshold of programming voltage, all switching regions are configured in the first condition. Below a second threshold of programming voltage all switching regions are configured in the second condition. The controller is configured to control the application of the programming voltage to apply a programming voltage between the first threshold and the second threshold, thereby to configure the first subset switching regions in the first condition, and to configure the second subset of the switching regions in the second condition. In this way, the switching device has an impedance characteristic.

Following programming of the switching device 100, a read voltage (e.g., a reading voltage, or use voltage) may be applied across the switching device 100. The read voltage is typically much lower than the programming voltage, such that mobile ion drift is not caused by the application of the read voltage. The state of the switching device 100 is thereby not altered by application of the read voltage. When the switching device 100 is configured in the first state, electrical current flows through the first subset of switching regions, and electrical charge builds up between electrodes corresponding to the second subset of switching regions. The switching device 100 thereby has an impedance characteristic. When the switching device 100 is configured in the second state, electrical current flows through all switching regions 140. The switching device 100 thereby has a resistive characteristic. When the switching device 100 is configured in the third state, electrical current does not flow through switching regions 140 but charge is built up between the electrodes. The switching device thereby has a capacitive characteristic. The switching device 100 can thereby be employed as a component which can be configured to have a level of impedance, resistance, or capacitance, depending on how the switching device 100 is configured by application of programming voltage.

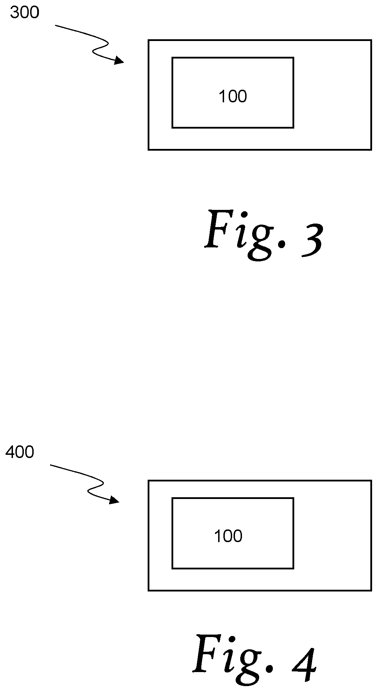

Referring to figure 3, an antenna 300 is shown. The antenna 300 comprises a switching device 100. The switching device 100 may have any or all of the features of the switching device 100 described above, as desired or as appropriate.

Advantageously, by the antenna 300 incorporating the switching device 100, antenna call tuning is facilitated. Furthermore, the antenna 300 may remain unobservable, or inactive, until an enabling RF signal is received, the enabling RF signal facilitating programming of the switching device 100. Additionally, signal coding and decoding at the antenna cell level is facilitated, as a jamming and signal spoofing countermeasure. In conventional examples, high power radiation may be incident on an antenna to attempt to jam or inhibit operation. A conventional approach involves sensing and processing this incoming signal, and subsequently instructing decoupling of the antenna. This occurs on the order of milliseconds or longer. However, the present switching device 100 may be preprogrammed to decouple at time of receipt of the signal, avoiding the need for signal sensing and processing, which may otherwise damage the antenna or processing electronics, or cause malfunction.

Referring to Figure 4, a frequency selective surface 400 is shown The frequency selective surface 400 comprises the switching device 100. The switching device 100 may have any or all of the features of the switching device 100 described above, as desired or as appropriate.

Advantageously, by the frequency selective surface 400 incorporating the switching device 100, the frequency selective surface 400 can be actively tuned.

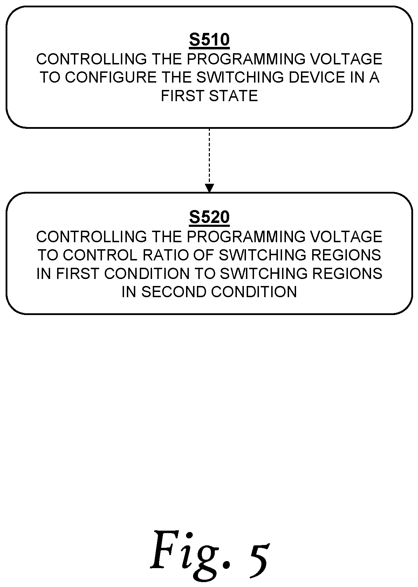

Referring to Figure 5, a method of use of a switching device is shown. The switching device comprises: a first electrode and a second electrode; and a dielectric substrate interposed between the first electrode and the second electrode, wherein the dielectric substrate comprises a plurality of switching regions, wherein the switching regions comprise mobile ions which are repositionable by application of a programming voltage. Step S510 comprises controlling the programming voltage to configure the switching device in a first state wherein: in a first subset of the plurality of switching regions, each switching region is in a first condition wherein the mobile ions are positioned so that a conductive path is provided across the switching region; and in a second subset of the plurality of switching regions, each switching region is in a second condition wherein the mobile ions are positioned so that a conductive path is not provided across the switching region.

Optional step S520 comprises controlling the programming voltage to control the ratio of switching regions in the first condition to switching regions in the second condition.

## Claims

1. A switching device (100) comprising:
a first electrode arrangement (110) and a second electrode arrangement (120); and
a dielectric substrate (130) between the first electrode arrangement (110) and the second electrode arrangement (120), wherein the dielectric substrate (130) comprises a plurality of switching regions (140),
wherein the switching regions (140) comprise mobile ions which are repositionable by application of a programming voltage,
wherein, by control of the programming voltage, the switching device is selectively configurable in a first state wherein:
in a first subset of the plurality of switching regions, each switching region is in a first condition wherein the mobile ions are positioned so that a conductive path is provided across the switching region; and
in a second subset of the plurality of switching regions, each switching region is in a second condition wherein the mobile ions are positioned so that a conductive path is not provided across the switching region.

2. The switching device (100) according to claim 1, wherein, in the first state, by control of the programming voltage, the ratio of the switching regions in the first condition to switching regions in the second condition is controllable by control of the programming voltage.

3. The switching device (100) according to claim 1 or claim 2, wherein, by control of the programming voltage, the switching device is further selectively configurable in a second state wherein:
each switching region of the plurality of switching regions is in the first condition.

4. The switching device (100) according to any one of the preceding claims, wherein, by control of the programming voltage, the switching device is further selectively configurable in a third state wherein:
each switching region of the plurality of switching regions is in the second condition.

5. The switching device (100) according to any one of the preceding claims, wherein the plurality of switching regions are integrally formed in the dielectric substrate (130).

6. The switching device (100) according to any one of the preceding claims, wherein the plurality of switching regions (140) are provided as a 2D array.

7. The switching device (100) according to any one of the preceding claims, wherein the switching regions are arranged in one or more linear arrays (140a, 140b, 140c) provided at a constant separation from the first electrode arrangement (110) and/or the second electrode arrangement (120).

8. The switching device (100) according to any one of the preceding claims, wherein the switching device comprises a wafer substrate (160), and wherein the dielectric substrate (130) is provided on one surface of the wafer substrate (160), wherein a gap (150) is provided between the dielectric substrate and the wafer substrate in at least an area of the dielectric substrate in which the plurality of switching regions (140) are provided.

9. The switching device (100) according to claim 8, wherein a plurality of apertures (180) are formed in the dielectric substrate (130) in the area of the dielectric substrate in which the plurality of switching regions (140) are provided.

10. The switching device (100) according to any one of the preceding claims, wherein the switching device further comprises a controller configured to control the application of the programming voltage.

11. The switching device (100) according to claim 10, wherein above a first threshold of programming voltage, all switching regions are configured in the first condition, and wherein below a second threshold of programming voltage, all switching regions are configured in the second condition, and wherein the controller is configured to control the application of the programming voltage to:
apply a programming voltage between first threshold and second threshold, thereby to configure first subset in first condition, and configure second subset in second condition.

12. An antenna (300) comprising the switching device (100) according to any one of the preceding claims.

13. A frequency selective surface (400) comprising the switching device (100) according to any one of the preceding claims.

14. A method of use of a switching device (100), the switching device comprising:
a first electrode arrangement (110) and a second electrode arrangement (120); and
a dielectric substrate (130) between the first electrode arrangement (110) and the second electrode arrangement (120), wherein the dielectric substrate (130) comprises a plurality of switching regions (140),
wherein the switching regions (140) comprise mobile ions which are repositionable by application of a programming voltage,
the method comprising:
controlling the programming voltage to configure the switching device in a first state wherein:
in a first subset of the plurality of switching regions, each switching region is in a first condition wherein the mobile ions are positioned so that a conductive path is provided across the switching region; and
in a second subset of the plurality of switching regions, each switching region is in a second condition wherein the mobile ions are positioned so that a conductive path is not provided across the switching region.

15. The method according to claim 14, further comprising controlling the programming voltage to control the ratio of switching regions in the first condition to switching regions in the second condition.
